# EUROPÄISCHE PATENTSCHRIFT

(11) **EP 2 043 176 B1**
(45) Veröffentlichungstag und Bekanntmachung des Hinweises auf die Patenterteilung: **09.01.2019**
(21) Anmeldenummer: 08164730.7
(22) Anmeldetag: 19.09.2008
(51) Int. Cl.: H01L 51/52, B60Q 1/26, B60Q 1/30, G02B 5/124, G09F 13/22, H01L 27/32, G09F 13/14, G09F 21/04

(54) **Beleuchtungseinrichtung, Leuchte und Anzeigevorrichtung**
Lighting device, lights and display device
Dispositif d'éclairage, éclairage et dispositif d'affichage

(30) Priorität: 28.09.2007 DE 102007046723; 13.11.2007 DE 102007054037
(43) Veröffentlichungstag der Anmeldung: 01.04.2009
(73) Patentinhaber: OSRAM OLED GmbH, 93049 Regensburg (DE)
(72) Erfinder: von Malm, Norwin, 93152, Thumhausen (DE)
(74) Vertreter: Epping - Hermann - Fischer

(56) Entgegenhaltungen:
- WO-A1-2007/043299
- JP-A- 2006 318 842
- JP-A- 2006 324 089
- US-A- 6 142 643
- US-A1- 2002 043 931

## Beschreibung

Beleuchtungseinrichtung, Leuchte und Anzeigevorrichtung Die vorliegende Anmeldung betrifft eine Beleuchtungseinrichtung, eine Leuchte und eine Anzeigevorrichtung.

Es ist eine Vielzahl verschiedener Beleuchtungseinrichtungen mit verschiedenen Leuchtmitteln bekannt. Beispiele für Leuchtmittel sind Glühlampen, Leuchtstoffröhren und Leuchtdioden.

Die JP 2006 318842 A betrifft eine Leuchtvorrichtung mit einem Substrat und einer organisch aktiven Schicht, die auf dem Substrat angeordnet ist. Auf einer dem Substrat abgewandten Seite der aktiven Schicht ist ein Retroreflektor angeordnet.

US2002/0043931 beschreibt eine organische lichtemittierende Vorrichtung mit einem Retroreflektor.

Es ist eine Aufgabe der vorliegenden Anmeldung, eine Beleuchtungseinrichtung anzugeben, die bei Nichtbetrieb eine gute Sichtbarkeit aufweist.

Eine erfindungsgemäße Beleuchtungseinrichtung ist in Anspruch 1 angegeben.

Diese Aufgabe wird durch eine Beleuchtungseinrichtung, eine Leuchte und eine Anzeigevorrichtung gemäß den nebengeordneten Patentansprüchen gelöst. Vorteilhafte Ausgestaltungen und Weiterbildungen sind jeweils in den abhängigen Ansprüchen angegeben, deren Offenbarungsgehalt hiermit ausdrücklich durch Rückbezug in die Beschreibung aufgenommen wird.

Es wird eine Beleuchtungseinrichtung angegeben. Die Beleuchtungseinrichtung weist ein organisches lichtemittierendes Bauelement auf. Weiter weist sie eine Lichtdurchtrittsfläche auf, die dazu vorgesehen ist, von dem organischen lichtemittierenden Bauelement emittiertes Licht aus der Beleuchtungseinrichtung auszukoppeln und Umgebungslicht in die Beleuchtungseinrichtung einzukoppeln.

Zudem weist die Beleuchtungseinrichtung einen Retroreflektor auf, der dazu vorgesehen ist, zumindest einen Teil des durch die Lichtdurchtrittsfläche eingekoppelten Umgebungslichts zur Lichtdurchtrittsfläche zurück zu reflektieren. Zumindest ein Teil des von dem Retroreflektor reflektierten Umgebungslichts wird vorteilhafterweise durch die Lichtdurchtrittsfläche hindurch aus der Beleuchtungseinrichtung ausgekoppelt.

Unter "Umgebungslicht" wird im vorliegenden Zusammenhang sichtbare elektromagnetische Strahlung verstanden, die außerhalb der Beleuchtungseinrichtung von einer externen Lichtquelle erzeugt ist. Als externe Lichtquelle kommen beispielsweise ein Scheinwerfer, etwa ein Fahrzeugscheinwerfer, eine Straßen- oder Innenraumbeleuchtung und/oder die Sonne in Frage.

Der Retroreflektor reflektiert für einen großen Bereich von Einfallswinkeln von der Lichtdurchtrittsfläche her auf den Retroreflektor einfallendes Umgebungslicht im wesentlichen in die gleiche Richtung zurück, aus der es kommt. Anders ausgedrückt verlaufen ein auf den Retroreflektor einfallender Teil und ein von dem Retroreflektor reflektierter Teil eines Lichtstrahls im Wesentlichen parallel. Der Einfallswinkel ist dabei der Winkel zwischen dem einfallenden Teil des Lichtstrahls und der Flächennormalen einer Haupterstreckungsebene des Retroreflektors. Insbesondere schließen der einfallende und der reflektierte Teil einen Winkel von kleiner oder gleich 15°, vorzugsweise von kleiner oder gleich 10°, besonders bevorzugt von kleiner oder gleich 5° ein. Eine Obergrenze für den Einfallswinkel ist beispielsweise größer oder gleich 45°, vorzugsweise größer oder gleich 60°, besonders bevorzugt größer oder gleich 75°.

Bei einer Weiterbildung weist der Retroreflektor eine geringfügige Streuung auf. Anders ausgedrückt wird der einfallende Teil des Lichtstrahls in einen schmalen, divergenten Strahlenkegel zurückreflektiert. Der Strahlenkegel hat eine Mittelachse, die im Wesentlichen parallel zu dem einfallenden Teil des Lichtstrahls verläuft, also mit diesem beispielsweise einen Winkel von kleiner oder gleich 15°, bevorzugt von kleiner oder gleich 10° und besonders bevorzugt von kleiner oder gleich 5° einschließt. Ein Öffnungswinkel des Strahlenkegels ist bevorzugt kleiner oder gleich 15°, besonders bevorzugt kleiner oder gleich 10° und insbesondere größer oder gleich 0,5°, vorzugsweise größer oder gleich 2°. Der Öffnungswinkel ist dabei der Winkel zwischen der Mittelachse und einer Hüllfläche des Strahlenkegels. Die Hüllfläche ist insbesondere die Menge aller Punkte, deren Abstand von der Mittelachse so gewählt ist, dass die Intensität der Strahlung auf 1/e der Intensität auf der Mittelachse abgefallen ist.

Die Retroreflexion in einen schmalen, divergenten Strahlenkegel ist beispielsweise vorteilhaft, wenn der von einer externen Lichtquelle - wie einem Scheinwerfer eines Fahrzeugs - einfallende Lichtstrahl nicht direkt in die externe Lichtquelle zurück reflektiert werden soll, sondern zum Beispiel von einem Beobachter in der Nähe der externen Lichtquelle - etwa dem Fahrzeugführer - wahrgenommen werden soll.

Das organische lichtemittierende Bauelement ist zumindest teilweise lichtdurchlässig. Vorzugsweise ist es transparent. Das organische lichtemittierende Bauelement oder zumindest dessen funktionale Schichtenfolge ist zwischen der Lichtdurchtrittsfläche und dem Retroreflektor angeordnet. Mit anderen Worten folgen in Richtung von einer Rückseite zu einer Vorderseite der Beleuchtungseinrichtung der Retroreflektor, die funktionale Schichtenfolge und die Lichtdurchtrittsfläche in dieser Reihenfolge aufeinander. Auf diese Weise wird insbesondere zumindest ein Teil des durch die Lichtdurchtrittsfläche in die Beleuchtungseinrichtung eingekoppelten Umgebungslichts durch das organische lichtemittierende Bauelement oder zumindest durch die funktionale Schichtenfolge hindurch geleitet und trifft auf den Retroreflektor. Vorteilhafterweise tritt somit insbesondere auch zumindest ein Teil des von dem Retroreflektor reflektierten und durch die Lichtdurchtrittsfläche hindurch aus der Beleuchtungseinrichtung ausgekoppelten Umgebungslichts durch das lichtdurchlässige organische lichtemittierende Bauelement.

Mittels des Retroreflektors wird mit Vorteil Umgebungslicht, das unter einem vorgegebenen Eintrittswinkel auf die Lichtdurchtrittsfläche trifft, in die Beleuchtungseinrichtung eingekoppelt und vom Retroreflektor zur Lichtdurchtrittsfläche zurück reflektiert wird, unter einem Austrittswinkel zur Lichtdurchtrittsfläche aus der Beleuchtungseinrichtung ausgekoppelt, der im wesentlichen den gleichen Wert hat, wie der Eintrittswinkel. Der Eintritts- beziehungsweise Austrittswinkel ist dabei der Winkel zu einer Flächennormale der Lichtdurchtrittsfläche. Beispielsweise hat eine Obergrenze für den Eintrittswinkel einen Wert von größer oder gleich 45°, vorzugsweise von größer oder gleich 60°, besonders bevorzugt von größer oder gleich 75°.

Mittels des vom Retroreflektor zur Lichtdurchtrittsfläche zurück reflektierten Umgebungslichts wird auch bei Nichtbetrieb, beispielsweise bei ausgeschaltetem organischen lichtemittierenden Bauelement und/oder bei einer Funktionsbeeinträchtigung wie einem Defekt des organischen lichtemittierenden Bauelements, eine gute Sichtbarkeit der Beleuchtungseinrichtung erzielt. Bei unzureichendem Umgebungslicht kann mittels des organischen lichtemittierenden Bauelements eine gute Sichtbarkeit der Beleuchtungseinrichtung erzielt werden.

Das organische lichtemittierende Bauelement weist eine funktionale Schichtenfolge auf. Die funktionale Schichtenfolge ist lichtdurchlässig, vorzugsweise transparent oder semitransparent. Mindestens eine Schicht der funktionalen Schichtenfolge enthält ein organisches Material. Beispielsweise handelt es sich bei dem organischen Material um ein Polymer und/oder um ein niedermolekulares Material (small molecules). Das organische Material ist insbesondere dazu vorgesehen, elektromagnetische Strahlung zu emittieren. Das organische lichtemittierende Bauelement stellt insbesondere eine organische Leuchtdiode (OLED, organic light emitting diode) dar. Zumindest ein Teil der von der funktionalen Schichtenfolge im Betrieb in Richtung des Retroreflektors emittierten elektromagnetischen Strahlung wird von diesem vorteilhafterweise in Richtung der Lichtdurchtrittsfläche zurück reflektiert und durch diese aus der Beleuchtungseinrichtung ausgekoppelt.

Die funktionale Schichtenfolge ist zwischen zwei Elektroden angeordnet, die - wie die funktionale Schichtenfolge selbst - zumindest teilweise lichtdurchlässig ausgebildet sind und vorzugsweise transparent oder semitransparent ausgebildet sind. Als Elektroden kommen beispielsweise Metallfilme in Frage, deren Dicke so gering gewählt ist, dass sie zumindest einen Teil des von der funktionalen Schichtenfolge emittierten Lichts transmittieren. Alternativ oder zusätzlich kann für eine oder beide Elektroden ein transparentes leitfähiges Oxid (TCO, transparent conducting oxide) wie Indiumzinnoxid (ITO, indium tin oxide) verwendet sein. Der funktionale Schichtstapel mit den Elektroden ist zweckmäßigerweise auf einem lichtdurchlässigen Substrat, insbesondere einem transparenten Substrat angeordnet. Das Substrat kann zum Beispiel eine Glasplatte, eine Glasfolie oder eine Polymerfolie aufweisen oder aus mindestens einem dieser Elemente bestehen.

Der Retroreflektor ist wellenlängenselektiv ausgeführt. Beispielsweise enthält er eine Farbfilterschicht. Die Farbfilterschicht transmittiert einen ersten spektralen Teilbereich des sichtbaren elektromagnetischen Spektrums und absorbiert einen weiteren spektralen Teilbereich des sichtbaren elektromagnetischen Spektrums. Alternativ zu einer Farbfilterschicht kann der Retroreflektor eine wellenlängenselektive Spiegelschicht zur Reflexion des Umgebungslichts enthalten, die den ersten Teilbereich reflektiert und den zweiten Teilbereich absorbiert und/oder transmittiert.

Vorzugsweise überlappt der erste spektrale Teilbereich teilweise oder vollständig mit der spektralen Verteilung des von dem organischen lichtemittierenden Bauelement im Betrieb der Beleuchtungseinrichtung emittierten Lichts. Bei einer Ausgestaltung hat ein Intensitätsmaximum des von dem organischen lichtemittierenden Bauelement emittierten Lichts eine Wellenlänge, die in dem ersten spektralen Teilbereich des sichtbaren Spektrums liegt. Gemäß der Erfindung reflektiert der wellenlängenselektiv ausgebildete Retroreflektor elektromagnetische Strahlung mit der Wellenlänge eines Emissionsmaximums des organischen lichtemittierenden Bauelements.

Gemäß der Erfindung erzeugt der Anteil des Umgebungslichts, der von dem Retroreflektor zur Lichtdurchtrittsfläche zurück reflektiert und aus der Beleuchtungseinrichtung ausgekoppelt wird, den gleichen Farbeindruck wie das von dem organischen lichtemittierenden Bauelement emittierte Licht. Mit Vorteil ruft die Beleuchtungseinrichtung unabhängig vom Betriebszustand des organischen lichtemittierenden Bauelements den gleichen Farbeindruck hervor.

Eine in dem Retroreflektor enthaltene Farbfilterschicht ist insbesondere zwischen dem organischen lichtemittierenden Bauelement und einer von der Lichtdurchtrittfläche abgewandten Seite, also der Rückseite der Beleuchtungseinrichtung, angeordnet. Bei einer anderen Ausgestaltung weist die Beleuchtungseinrichtung eine Farbfilterschicht auf, die zumindest stellenweise zwischen der Lichtdurchtrittsfläche und dem organischen lichtemittierenden Bauelement angeordnet ist. In Draufsicht auf die Lichtdurchtrittsfläche bedeckt die Farbfilterschicht das organische lichtemittierende Bauelement und den Retroreflektor bei dieser Ausgestaltung stellenweise oder vollflächig. Die Farbfilterschicht ist bei einer Weiterbildung mit einer Verkapselung des organischen lichtemittierenden Bauelements ausgebildet. Beispielsweise enthält die Verkapselung mindestens einen Farbstoff zur Bildung der Farbfilterschicht.

Bei einer Weiterbildung, bei der die Farbfilterschicht stellenweise zwischen der Lichtdurchtrittsfläche und dem organischen lichtemittierenden Bauelement angeordnet ist, wird ein erster spektraler Anteil des von dem organischen lichtemittierenden Bauelement emittierten Lichts von der Farbfilterschicht transmittiert und ein zweiter spektraler Anteil des von dem organischen lichtemittierenden Bauelement emittierten Lichts wird von der Farbfilterschicht absorbiert.

Beispielsweise emittiert das organische lichtemittierende Bauelement weißes Licht. Die Farbfilterschicht absorbiert einen kurzwelligen, zweiten spektralen Teilbereich des sichtbaren Spektralbereichs, beispielsweise absorbiert sie im blauen und grünen Spektralbereich, und transmittiert rotes Licht als ersten spektralen Teilbereich. Die von der Farbfilterschicht in Draufsicht auf die Lichtdurchtrittsfläche unbedeckten Stellen des organischen lichtemittierenden Bauelements erscheinen auf diese Weise mit dem Farbeindruck, welcher der von dem organischen lichtemittierenden Bauelement erzeugten spektralen Verteilung entspricht. Die von der Farbfilterschicht bedeckten Teilgebiete erscheinen in der Farbe, die dem von der Farbfilterschicht transmittierten ersten spektralen Teilbereich entspricht. Vorteilhafterweise wird so mittels eines einzelnen organischen lichtemittierenden Bauelements die Darstellung einer Information erzielt, beispielsweise eines Musters und/oder mindestens eines Symbols. Bei dem Symbol oder den Symbolen handelt es sich beispielsweise um einen oder mehrere Buchstaben, eine oder mehrere Ziffern und/oder ein oder mehrere Piktogramme.

Bei einer anderen Ausgestaltung ist eine Mehrzahl von organischen lichtemittierenden Bauelementen in Draufsicht auf die Lichtdurchtrittsfläche lateral nebeneinander angeordnet. Bei einer Weiterbildung dieser Ausgestaltung sind mindestens zwei der lateral nebeneinander angeordneten organischen lichtemittierenden Bauelemente unterschiedliche Farbfilter zugeordnet. Beispielsweise bedeckt der jeweilige Farbfilter das organischen lichtemittierenden Bauelement, dem er zugeordnet ist, in Draufsicht auf die Lichtdurchtrittsfläche stellenweise oder vollständig. Insbesondere hat ein Intensitätsmaximum des von dem jeweiligen organischen lichtemittierenden Bauelement emittierten Lichts eine Wellenlänge, die in dem ersten spektralen Teilbereich der dem Bauelement zugeordneten Farbfilterschicht liegt.

Bei einer weiteren Ausgestaltung weist die Beleuchtungseinrichtung eine Mehrzahl von organischen lichtemittierenden Bauelementen auf, deren funktionale Schichtenfolgen lateral überlappen. Mit anderen Worten folgen die organischen lichtemittierenden Bauelemente in Richtung von der Vorderseite zur Rückseite der Beleuchtungseinrichtung aufeinander. Anders ausgedrückt ist die Mehrzahl von organischen lichtemittierenden Bauelementen aufeinander gestapelt. Beispielsweise ist der Stapel organischer lichtemittierender Bauelemente dazu geeignet, weißes Licht zu emittieren.

Die Mehrzahl von organischen lichtemittierenden Bauelementen, die lateral nebeneinander angeordnet sind und/oder die Mehrzahl von organischen lichtemittierenden Bauelementen, deren funktionale Schichtenfolgen lateral überlappen, sind bei einer Weiterbildung einzeln oder in Teilgruppen ansteuerbar. Auf diese Weise wird eine Beleuchtungseinrichtung erzielt, deren Farbeindruck und/oder deren dargestellte Information im Betrieb variierbar ist.

Der Retroreflektor enthält bei einer Ausgestaltung eine Spiegelschicht, die eine Mehrzahl von Strahlformungselementen aufweist. Die Strahlformungselemente sind vorzugsweise in einer Monolage angeordnet. Zweckmäßigerweise hat die Spiegelschicht eine zumindest stellenweise reflektierende Oberfläche. Zum Beispiel ist eine zur Lichtdurchtrittsfläche hin gewandte Hauptfläche der Spiegelschicht reflektierend. Die Spiegelschicht weist insbesondere ein metallisches Material auf. Beispielsweise weist sie einen reflektierenden Metallfilm auf. Alternativ kann die Reflexion an der Oberfläche der Spiegelschicht auch mittels Totalreflexion erfolgen, insbesondere an einer zur von der Lichtdurchtrittsfläche abgewandten Hauptfläche der Spiegelschicht. Eine Spiegelschicht, die zur (Total-)Reflexion an einer von der Lichtdurchtrittsfläche abgewandten Hauptfläche vorgesehen ist, enthält vorzugsweise ein zumindest teilweise lichtdurchlässiges, insbesondere transparentes oder semitransparentes Material. Eine solche Spiegelschicht kann integriert mit der Farbfilterschicht ausgebildet sein.

Bei einer Ausgestaltung weist mindestens ein Strahlformungselement eine Vertiefung in der Oberfläche der Spiegelschicht auf oder besteht daraus. Beispielsweise hat die Vertiefung die Form eines Prismas, eines Kegels, eines Kegelstumpfs oder Pyramidenstumpfs. Sie ist beispielsweise mittels eines Prägeprozesses in der Spiegelschicht hergestellt. Weist die Spiegelschicht einen reflektierenden Metallfilm auf einem Träger auf, erfolgt die Prägung der Vertiefungen in den Träger vorzugsweise vor der Herstellung des reflektierenden Metallfilms.

Bei einer weiteren Ausgestaltung weist mindestens eines der Strahlformungselemente ein Linsenelement auf oder besteht daraus. Bei dem Linsenelement kann es sich beispielsweise um Glaskugeln, anorganische Körner mit hohem Brechungsindex und/oder um Glassplitter handeln. Das Linsenelement ist bei einer Weiterbildung des Retroreflektors in einer Vertiefung der Spiegelschicht angeordnet und ragt insbesondere über die Öffnung der Vertiefung hinaus.

Alternativ kann der Retroreflektor eine teilweise lichtdurchlässige, transluzente oder transparente Trägerschicht aufweisen, die eine Mehrzahl von Strahlformungselementen enthält, welche stellenweise reflektierend ausgeführt sind. Als teilweise reflektierend ausgeführte Strahlformungselemente sind beispielsweise teilmetallisierte Glaskugeln geeignet. Die Strahlformungselemente sind vorzugsweise in einer Monolage in der Trägerschicht enthalten. Die reflektierenden Stellen sind zweckmäßigerweise von der Lichtdurchtrittsfläche abgewandt.

Die Strahlformungselemente sind bei einer Ausgestaltung miniaturisiert ausgeführt. Beispielsweise ist ihre größte Längenausdehnung kleiner oder gleich 1 mm, bei einer Weiterbildung ist sie kleiner oder gleich 250 µm, beispielsweise kleiner oder gleich 100 µm.

Bei einer weiteren Ausgestaltung ist die Beleuchtungseinrichtung flexibel ausgeführt. Eine flexibel ausgeführte Beleuchtungseinrichtung ist mit Vorteil besonders vielseitig einsetzbar.

Bei einer Ausgestaltung ist die Beleuchtungseinrichtung in einer Leuchte enthalten oder stellt eine Leuchte dar. Die Leuchte ist insbesondere eine Leuchte für ein Verkehrsmittel oder für eine Straßenbeleuchtung. Beispielsweise ist die Leuchte eine Positionsleuchte eines Fahrzeugs, etwa eines Kraftfahrzeugs oder Fahrrads. Bei dieser Ausgestaltung ist - insbesondere mittels des Retroreflektors - mit Vorteil ein Rückstrahler - der zum Beispiel an dem Fahrzeug vorgesehen ist - in der Leuchte - die beispielsweise eine Rückleuchte eines Kraftfahrzeugs ist - integriert. Auf diese Weise ist der Platzbedarf für Leuchte und Rückstrahler vorteilhafterweise besonders gering.

Bei einer anderen Ausgestaltung ist die Beleuchtungseinrichtung in einer Anzeigevorrichtung enthalten. Die Anzeigevorrichtung ist insbesondere dazu vorgesehen, eine Information darzustellen. Bei der Information kann es sich beispielsweise um mindestens ein Symbol, um mindestens eine geometrische Form wie einen Kreis, ein Dreieck, ein Rechteck, usw. und/oder um mindestens eine grafische Information wie eine Zeichnung oder ein Foto handeln. Beispielsweise handelt es sich bei der Anzeigevorrichtung um eine Anzeigetafel, zum Beispiel um eine Richtungshinweistafel - etwa im Straßenverkehr -, eine Warntafel, ein Verkehrszeichen oder ein Nummernschild. Die Information ist insbesondere auch bei ausgeschaltetem oder defektem lichtemittierendem Bauelement besonders gut sichtbar.

Bei einer weiteren Ausgestaltung ist ein Bekleidungsstück oder ein Gepäckstück mit der Beleuchtungseinrichtung und/oder der Anzeigevorrichtung versehen. Bei dem Bekleidungsstück handelt es sich beispielsweise um eine Jacke oder um einen Schuh. Das Gepäckstück ist beispielsweise ein Schulranzen, ein Rucksack, eine Tasche wie eine Reise- oder Sporttasche oder ein Koffer.

Bei einer vorteilhaften Weiterbildung ist die Beleuchtungseinrichtung und/oder die Anzeigevorrichtung flexibel, insbesondere also biegsam und/oder formbar, ausgebildet. Bei einer anderen Weiterbildung ist eine Stromversorgungseinheit in das Kleidungsstück oder das Gepäckstück integriert, welche die Beleuchtungseinrichtung und/oder Anzeigevorrichtung im Betrieb mit Strom versorgt.

Weitere Vorteile und vorteilhafte Ausgestaltungen und Weiterbildungen der Beleuchtungseinrichtung ergeben sich aus den im Folgenden im Zusammenhang mit den Figuren 1A bis 13 dargestellten Ausführungsbeispielen.

Es zeigen:
- Figur 1A: einen schematischen Querschnitt durch eine Beleuchtungseinrichtung gemäß einem ersten Ausführungsbeispiel,
- Figur 1B: einen schematischen Querschnitt durch eine Beleuchtungseinrichtung gemäß einem Beispiel, das nicht zur Erfindung gehört,

- Figur 2: einen schematischen Querschnitt durch eine Beleuchtungseinrichtung gemäß einem zweiten Ausführungsbeispiel,
- Figur 3: einen schematischen Querschnitt durch eine Leuchte mit zwei Beleuchtungseinrichtungen gemäß einer zweiten Variante des ersten Ausführungsbeispiels,
- Figur 4: eine schematische Seitenansicht eines Fahrrads mit mehreren Beleuchtungseinrichtungen,
- Figur 5: eine schematische Rückansicht eines Kraftfahrzeugs mit einer Mehrzahl von Beleuchtungseinrichtungen,
- Figur 6: eine schematische Darstellung eines Bekleidungsstücks mit einer Mehrzahl von Beleuchtungseinrichtungen,
- Figur 7: eine schematische Darstellung eines Gepäckstücks mit einer Mehrzahl von Beleuchtungseinrichtungen,
- Figur 8: einen schematischen Querschnitt durch eine Beleuchtungseinrichtung gemäß einem dritten Ausführungsbeispiel,
- Figur 9: eine schematische Draufsicht auf eine Warnmarkierung mit einer Beleuchtungseinrichtung gemäß dem dritten Ausführungsbeispiel,
- Figur 10: eine schematische perspektivische Ansicht eines Lastkraftwagens mit mehreren Beleuchtungseinrichtungen,
- Figur 11: eine schematische Draufsicht auf eine Anzeigevorrichtung gemäß einem ersten Ausführungsbeispiel,
- Figur 12: eine schematische Draufsicht auf eine Anzeigevorrichtung gemäß einem zweiten Ausführungsbeispiel, und
- Figur 13: eine schematische Darstellung einer Anzeigevorrichtung gemäß einem dritten Ausführungsbeispiel.

In den Ausführungsbeispielen und Figuren sind gleiche oder gleich wirkende Bestandteile mit denselben Bezugszeichen versehen. Die Figuren und die Größenverhältnisse der in den Figuren dargestellten Elemente untereinander sind grundsätzlich nicht als maßstabsgetreu zu betrachten. Vielmehr können einzelne Elemente wie Schichten zur besseren Darstellbarkeit und/oder zum besseren Verständnis übertrieben groß, insbesondere übertrieben dick, dargestellt sein.

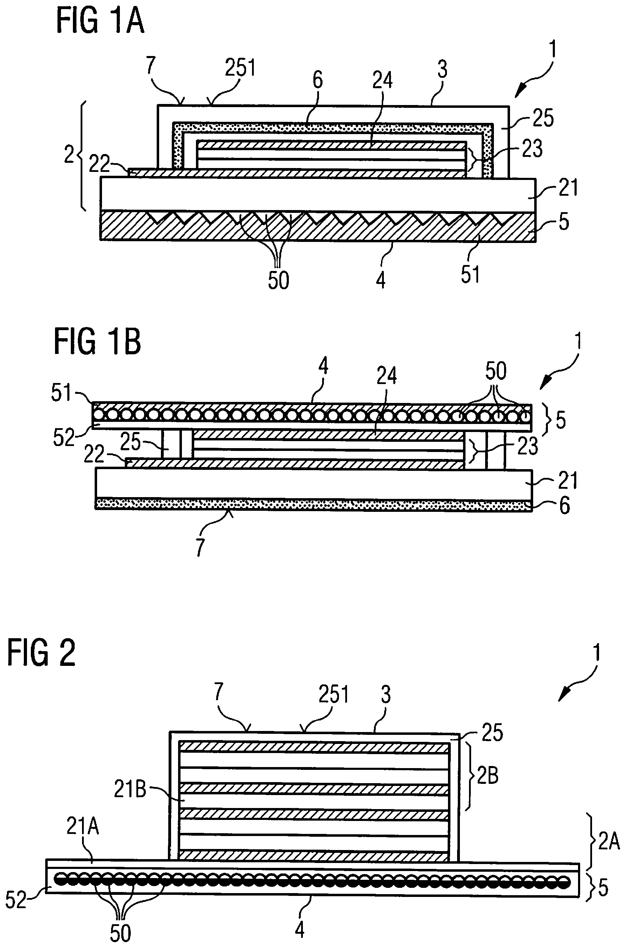

Figur 1A zeigt einen schematischen Querschnitt durch eine Beleuchtungseinrichtung 1 gemäß einem ersten Ausführungsbeispiel. Die Beleuchtungseinrichtung 1 weist ein organisches Licht emittierendes Bauelement 2 auf, das ein Substrat 21 enthält, auf welches eine erste Elektrode 22 aufgebracht ist. Auf die erste Elektrode 22 ist an der vom Substrat 21 abgewandten Seite eine funktionale Schichtenfolge 23 aufgebracht, die auf einem organischen Material, wie einem Polymermaterial und/oder einem niedermolekularen Material, basiert. Auf der von der ersten Elektrode 22 abgewandten Seite der funktionalen Schichtenfolge 23 ist eine zweite Elektrode 24 angeordnet. Eine Verkapselung 25, vorliegend eine Kappe schützt die funktionale Schichtenfolge 23 vor mechanischer Beschädigung, Verschmutzung und/oder Feuchtigkeit. Die Kappe 25 ist zum Beispiel eine Glaskappe oder eine Kunststoffkappe, die beispielsweise Polycarbonat enthält.

Die erste und die zweite Elektrode sind vorzugsweise zum elektrischen Anschließen des organischen Licht emittierenden Bauelements 2 durch die Verkapselung 25 hindurch in den Außenraum geführt. Bei Einprägen eines Betriebsstroms in die funktionale Schichtenfolge 23 mittels der ersten und der zweiten Elektrode 22, 24 wird eine aktive Zone der funktionalen Schichtenfolge 23 zur Emission von elektromagnetischer Strahlung angeregt.

Die Beleuchtungseinrichtung ist zur Emission elektromagnetischer Strahlung von einer Vorderseite 3 vorgesehen. Die Vorderseite 3 ist bei dem vorliegenden Ausführungsbeispiel die von dem Substrat 21 abgewandte Seite des organischen Licht emittierenden Bauelements 2. An der Vorderseite 3 weist die Beleuchtungseinrichtung 1 eine Lichtdurchtrittsfläche 7 auf. Vorliegend stellt eine von dem funktionalen Schichtstapel 23 abgewandte Hauptfläche 251 der Verkapselung 25 die Lichtdurchtrittsfläche dar.

An der der Vorderseite 3 gegenüberliegenden Rückseite 4 weist die Beleuchtungseinrichtung 1 einen Retroreflektor 5 auf. Der Retroreflektor 5 weist bei dem ersten Ausführungsbeispiel eine Metallplatte als Spiegelschicht auf, deren der Vorderseite 3 zugewandte Hauptfläche zumindest in dem von dem organischen Licht emittierenden Bauelement 2 bedeckten Bereich mittels Strahlformungselementen 50 versehen ist. Bei den Strahlformungselementen 50 handelt es sich vorliegend um in die reflektierende Metallplatte 51 eingeprägte, pyramidenförmige Vertiefungen. Mittels der Vertiefungen 50 reflektiert der Retroreflektor 5 Umgebungslicht, das von der Lichtdurchtrittsfläche 7 her auf den Retroreflektor 5 trifft, im Wesentlichen in diejenige Richtung zurück, aus der es auf den Retroreflektor 5 trifft.

Vorzugsweise stellen die pyramidenförmigen Vertiefungen 50 Tripelspiegel dar. Anders ausgedrückt hat jede Vertiefung vorzugsweise genau drei Seitenflächen. Bei einer Weiterbildung schließen die 3 Seitenflächen jeweils einen Winkel von etwa 90° zueinander ein, zum Beispiel einen Winkel zwischen 85 und 95°, wobei die Grenzen eingeschlossen sind.

Das organische Licht emittierende Bauelement 2 ist zumindest teilweise lichtdurchlässig ausgeführt. Vorzugsweise ist es transparent ausgeführt. Insbesondere sind das Substrat 21, die erste und zweite Elektrode 22, 24 und der funktionale Schichtstapel 23 jeweils zumindest teilweise lichtdurchlässig und insbesondere transparent oder semitransparent.

Beispielsweise handelt es sich bei dem Substrat 21 um eine Glasplatte, eine Glasfolie oder eine Polymerfolie. Für die erste und zweite Elektrode 22, 24 sind transparente leitfähige Oxide wie ITO und/oder semitransparente Metallschichten als Materialien geeignet. Auf diese Weise wird zumindest ein Teil des durch die Lichtdurchtrittsfläche 7 in die Beleuchtungseinrichtung 1 eingekoppelten Umgebungslichts durch das organische lichtemittierende Bauelement 2 hindurch geleitet und trifft auf den Retroreflektor 5. Von diesem wird es - insbesondere durch das organische lichtemittierende Bauelement 2 hindurch - zumindest teilweise zur Lichtdurchtrittsfläche 7 zurückreflektiert. Auf diese Weise wird zumindest ein Teil des in die Beleuchtungseinrichtung 1 eingekoppelten Umgebungslichtes wieder aus der Beleuchtungseinrichtung 1 ausgekoppelt, wobei Eintritts- und Austrittswinkel im Wesentlichen gleich sind, sich also insbesondere um 15° oder weniger, vorzugsweise um 10° oder weniger, besonders bevorzugt um 5° oder weniger unterscheiden.

Zusätzlich wird zumindest ein Teil der von der funktionalen Schichtenfolge 23 im Betrieb der Beleuchtungseinrichtung 1 in Richtung der Rückseite 4 emittierten elektromagnetischen Strahlung von dem Retroreflektor 5 in Richtung der Vorderseite 3 zurück reflektiert und durch die Lichtdurchtrittsfläche 7 hindurch ausgekoppelt.

Zwischen der Lichtdurchtrittsfläche 7 und der funktionalen Schichtenfolge 23 ist eine Farbfilterschicht 6 angeordnet. Die Farbfilterschicht 6 ist vorliegend auf eine der funktionalen Schichtenfolge 23 zugewandte Innenfläche der Kappe 25 aufgebracht. Die Farbfilterschicht 6 hat einen hohen Transmissionskoeffizienten für einen ersten spektralen Teilbereich des sichtbaren Wellenlängenspektrums und einen hohen Absorptionskoeffizienten für einen zweiten spektralen Teilbereich des sichtbaren Wellenlängenspektrums. Ein Intensitätsmaximum der von der funktionalen Schichtenfolge 23 im Betrieb der Beleuchtungseinrichtung 1 emittierten elektromagnetischen Strahlung liegt innerhalb des von der Farbfilterschicht 6 transmittierten ersten spektralen Teilbereichs.

In Figur 1B ist eine Beleuchtungseinrichtung 1 gemäß einem Beispiel, das nicht zur Erfindung gehört, in einem schematischen Querschnitt dargestellt.

Im Gegensatz zum ersten Ausführungsbeispiel gemäß Figur 1A ist der Retroreflektor 5 vorliegend auf der vom Substrat 21 des organischen Licht emittierenden Bauelements 2 abgewandten Seite angeordnet. Vorliegend folgen in Richtung von der Rückseite 4 zur Vorderseite 3 der Beleuchtungseinrichtung 1 der Retroreflektor 5, die funktionale Schichtenfolge 23 und das Substrat 21 in dieser Reihenfolge aufeinander, während beim Ausführungsbeispiel der Figur A die funktionale Schichtenfolge 23 dem Substrat 21 in Richtung von der Rückseite 4 zur Vorderseite 3 nachfolgt.

Bei der in Figur 1B dargestellten Variante bildet beispielsweise der Retroreflektor 5, insbesondere zusammen mit einem Verkapselungsrahmen 25, die Verkapselung oder einen Teil der Verkapselung der funktionalen Schichtenfolge 23. Der Verkapselungsrahmen 25 ist beispielsweise ein Distanzring, zum Beispiel aus einem Kunststoff- oder Glasmaterial. Alternativ kann es sich bei dem Verkapselungsrahmen 5 auch um eine Klebstoffraupe handeln, mittels welcher der Retroreflektor 5 an dem Substrat 21 des organischen Licht emittierenden Bauelements befestigt ist.

Die Beleuchtungseinrichtung gemäß Figur 1B weist ebenfalls eine Farbfilterschicht 6 auf. Diese ist vorliegend auf die von der funktionalen Schichtenfolge abgewandten Hauptfläche des Substrats 21 aufgebracht. Alternativ kann auch das Substrat 21 die Farbfilterschicht 6 darstellen, beispielsweise enthält das Substrat 21 zu diesem Zweck einen Farbstoff.

Der Retroreflektor 5 ist bei der Variante gemäß Figur 1B eine Reflektorfolie, die eine Spiegelschicht 51, eine Mehrzahl von Linsenelementen 50 und eine zumindest teilweise lichtdurchlässige, vorzugweise transparente Deckschicht 52 enthält. Bei den Linsenelementen handelt es sich beispielsweise um Glaskugeln, die zum Beispiel einen Durchmesser von kleiner oder gleich 100 µm, insbesondere von kleiner oder gleich 50 µm haben. Die Glaskugeln 50 sind teilweise in die Spiegelschicht 51 eingebettet, sodass diese Vertiefungen aufweist, in denen die Glaskugeln 50 angeordnet sind, und über welche die Glaskugeln 50 hinausragen. Die Deckschicht 52 schützt die Strahlformungselemente insbesondere vor Verschmutzung und/oder mechanischer Beschädigung. Bei einem wellenlängenselektiven Retroreflektor kann die Deckschicht eine Farbfilterschicht darstellen und zum Beispiel einen Farbstoff enthalten.

Von der Vorderseite 3 auf das Linsenelement 50 treffendes Licht wird beim Eintritt in das Linsenelement 50 gebrochen, an der Spiegelschicht 51 reflektiert und beim Austritt aus dem Linsenelement 50 wiederum gebrochen. Das auf diese Weise reflektierte Licht wird insbesondere im Wesentlichen in diejenige Richtung zurückreflektiert, aus der es auf das Linsenelement auftrifft.

Figur 2 zeigt einen schematischen Querschnitt durch eine Beleuchtungseinrichtung 1 gemäß einem zweiten Ausführungsbeispiel. Die Beleuchtungseinrichtung gemäß dem zweiten Ausführungsbeispiel weist im Gegensatz zu der des ersten Ausführungsbeispiels keinen Farbfilter auf.

Der Retroreflektor 5 ist mittels Partikeln aus einem anorganischen Material gebildet. Bei den Partikeln kann es sich beispielsweise um Glas- oder Glaskeramikpartikel handeln. Die Partikel haben beispielsweise polygonale Außenflächen, zum Beispiel handelt es sich um Glassplitter, oder sie haben eine abgerundete Form, beispielsweise im Wesentlichen die Form einer Kugel oder eines Ellipsoids. Es kann sich bei den Partikeln um Vollkörper oder um Hohlkörper handeln. Vorliegend sind die Strahlformungselemente 50 Glaskugeln mit einem Durchmesser von kleiner oder gleich 100 µm, insbesondere von kleiner oder gleich 50 µm. Die Oberfläche der Partikel ist vorliegend teilweise verspiegelt. Der verspiegelte Teil der Oberfläche der Glaskügelchen 50 ist zweckmäßigerweise der Rückseite 4 der Beleuchtungseinrichtung 1 zugewandt und von der Lichtdurchtrittsfläche 7 abgewandt. Alternativ zu Partikeln mit einer teilverspiegelten Oberfläche können auch unverspiegelte Partikel verwendet sein, die mittels Totalreflexion reflektieren.

Die Strahlformungselemente 50 sind in einer Monolage in dem Retroreflektor 5 enthalten und in einer transparenten Trägerschicht 52, die beispielsweise ein Polymer-Material enthält, eingebettet. Das Material der Trägerschicht 52 hat insbesondere einen Brechungsindex, der geringer ist als der Brechungsindex der Strahlformungselemente 50. Bei einer Ausgestaltung ist der Brechungsindex der Strahlformungselemente 50 zwischen 1,5 und 2,5 mal so groß wie der Brechungsindex der Trägerschicht 52, wobei die Grenzen eingeschlossen sind. Bei einen wellenlängenselektiven Rektroreflektor 5 ist beispielsweise eine Farbfilterschicht integriert mit der Trägerschicht 52 ausgebildet. Beispielsweise enthält die Trägerschicht 52 dazu einen Farbstoff.

Ein weiterer Unterschied zum ersten Ausführungsbeispiel besteht darin, dass die Beleuchtungseinrichtung gemäß der Figur 2 zwei organische lichtemittierende Bauelemente 2A, 2B aufweist, die in Richtung von der Rückseite 4 zur Vorderseite 3 übereinander gestapelt sind. Vorliegend sind die beiden organischen lichtemittierenden Bauelemente 2A, 2B in einer gemeinsamen Verkapselung 25 angeordnet.

Die Beleuchtungseinrichtung 1 ist vorliegend flexibel ausgeführt. Die Substrate 21A, 21B der organischen lichtemittierenden Bauelemente 2A, 2B sind zum Beispiel Polymerfolien. Die Verkapselung ist bei dem vorliegenden Ausführungsbeispiel eine transparente Dünnfilmverkapselung 25, die mindestens eine dielektrische Schicht, zum Beispiel eine SiO₂-Schicht, eine Si₃N₄-Schicht und/oder eine Oxinitridschicht aufweist. Vorzugsweise enthält die Dünnschichtverkapselung einen Schichtstapel aus alternierenden dielektrischen Schichten und Polymerschichten. Eine derartige Dünnfilmverkapselung 25 ist auch für andere Ausgestaltungen der Beleuchtungseinrichtung geeignet.

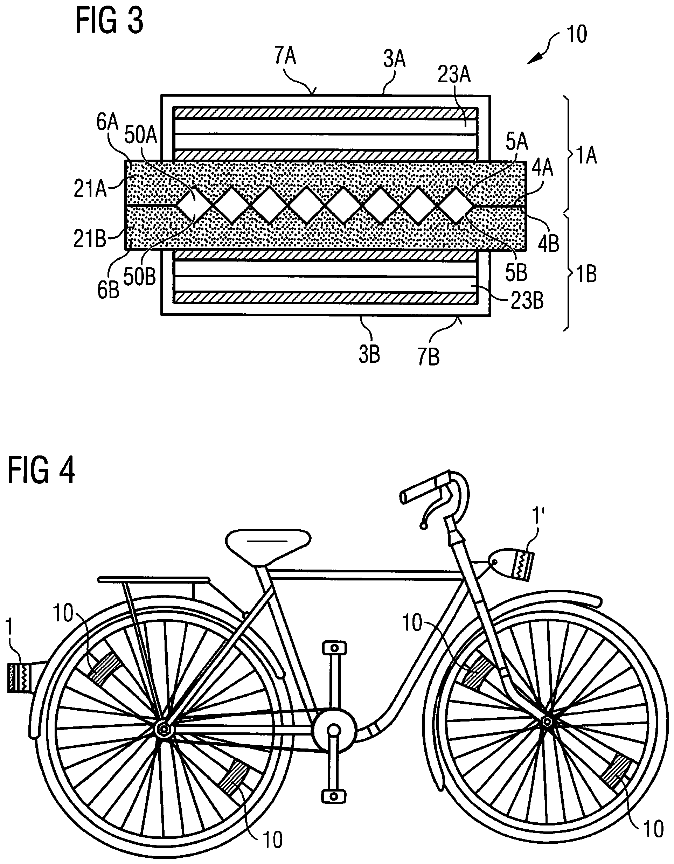

In Figur 3 ist ein schematischer Querschnitt durch eine Leuchte 10 mit zwei Beleuchtungseinrichtungen 1A, 1B gemäß einer zweiten Variante des ersten Ausführungsbeispiels dargestellt. Die beiden Beleuchtungseinrichtungen 1A und 1B sind so angeordnet, dass ihre Rückseiten 4A, 4B und insbesondere ihre Retroreflektoren 5A, 5B einander zugewandt sind. Vorzugsweise sind die Rückseiten 4A, 4B der beiden Beleuchtungseinrichtungen aneinander befestigt. Die Vorderseiten 3A, 3B der Beleuchtungseinrichtungen 1A, 1B liegen auf diese Weise einander gegenüber, so dass die Lichtdurchtrittsflächen 7A, 7B voneinander abgewandt sind. So beleuchtet die Leuchte 10 einen großen Raumwinkelbereich und/oder ist zur Retroreflexion von Umgebungslicht aus einem großen Raumwinkelbereich geeignet.

Die folgenden, anhand der ersten Beleuchtungseinrichtung 1A erläuterten Merkmale gelten entsprechend auch für die zweite Beleuchtungseinrichtung 1B der Leuchte 10.

Bei dem vorliegenden Ausführungsbeispiel ist der Retroreflektor 5 mit dem Substrat 21A der Beleuchtungseinrichtung 1A integriert ausgebildet. Eine rückseitige Hauptfläche des Substrats 21A ist mit Vertiefungen 50A strukturiert.

Im Gegensatz zu dem Retroreflektor 5 des ersten Ausführungsbeispiels gemäß Figur 1A erfolgt die Reflexion eben nicht an einer der Vorderseite 3 zugewandten Fläche einer reflektierenden, Spiegelschicht 51, die ein lichtundurchlässiges Material enthält. Vielmehr erfolgt die Reflexion vorliegend mittels Totalreflexion an den Flanken der Vertiefungen 50A. Das Substrat 21A enthält vorliegend ein transparentes Matrixmaterial und einen in dem Matrixmaterial dispergierten Farbstoff, der einen ersten spektralen Teilbereich des sichtbaren Spektrums transmittiert und einen zweiten spektralen Teilbereich des sichtbaren Spektrums absorbiert. Auf diese weise reflektiert der Retroreflektor 5A im Wesentlichen nur Umgebungslicht mit einer Wellenlänge innerhalb des ersten spektralen Teilbereichs zur Lichtdurchtrittsfläche 7A zurück. Ein Intensitätsmaximum der von der funktionalen Schichtenfolge 23a im Betrieb emittierten Strahlung hat vorzugsweise ebenfalls eine Wellenlänge im ersten spektralen Teilbereich.

Das Substrat 21A stellt vorliegend eine Farbfilterschicht 6A dar. Alternativ kann das Substrat 21A dazu auch ein farbiges Matrixmaterial enthalten. Ist eine Wellenlängenselektivität des Retroreflektors nicht erwünscht, ist das Substrat 21A zweckmäßigerweise transparent ausgeführt. Ein Retroreflektor 5A, der ausgeführt ist wie bei dem vorliegenden Ausführungsbeispiel, ist auch für andere Ausgestaltungen der Beleuchtung geeignet.

Die Farbfilterschicht 6A, die bei dem vorliegenden Ausführungsbeispiel mit dem Substrat 21A integriert ausgebildet ist, folgt der funktionalen Schichtenfolge 23A in Richtung zu der Rückseite 4A hin nach. Auf diese Weise wird die Gefahr verringert, dass von der funktionalen Schichtenfolge 23A in Richtung der vorderseitigen Lichtdurchtrittsfläche 7A emittiertes Licht von der Farbfilterschicht 6A absorbiert wird.

In Figur 4 ist ein Fahrrad in schematischer Seitenansicht dargestellt, das als Rückleuchte eine Beleuchtungseinrichtung 1 gemäß dem ersten Ausführungsbeispiel der Figur 1A aufweist. Beispielsweise emittiert das lichtemittierende Bauelement 2 der Rückleuchte 1 rotes Licht und die Farbfilterschicht 6 ruft einen roten Farbeindruck hervor.

Alternativ oder zusätzlich weist das Fahrrad einen Scheinwerfer 1' auf, welcher beispielsweise eine Beleuchtungseinrichtung gemäß dem zweiten Ausführungsbeispiel der Figur 2 enthält.

Zum Beispiel sind bei dem Scheinwerfer 1' ein erstes organisches lichtemittierendes Bauelement 2A, das gelbes Licht emittiert, und ein zweites organisches lichtemittierendes Bauelement 2B, das blaues Licht emittiert, übereinander gestapelt. Auf diese Weise emittiert der Scheinwerfer 1' im Betrieb weißes Licht. Alternativ kann der Scheinwerfer auch ein organisches lichtemittierendes Bauelement 2 enthalten, das mittels einer einzigen funktionalen Schichtenfolge 23 weißes Licht emittiert. Weiterhin alternativ ist auch ein Stapel von drei lichtemittierenden Bauelementen denkbar, die beispielsweise rotes, grünes und blaues Licht emittieren.

Weiterhin alternativ oder zusätzlich weist das Fahrrad Rückstrahler 10 in den Speichen der Räder auf, welche vorliegend Leuchten gemäß dem Ausführungsbeispiel der Figur 3 enthalten. Die Leuchten 10 enthalten zum Beispiel eine - in Figur 3 nicht dargestellte - Stromversorgungsvorrichtung wie eine Batterie oder einen Akkumulator. Rückleuchte 1 und/oder Scheinwerfer 1' können ebenfalls eine Batterie- oder einen Akkumulator zur Stromversorgung enthalten und/oder sie können mittels einer externen Stromversorgungsvorrichtung wie eines Dynamos mit Betriebsstrom versorgt werden.

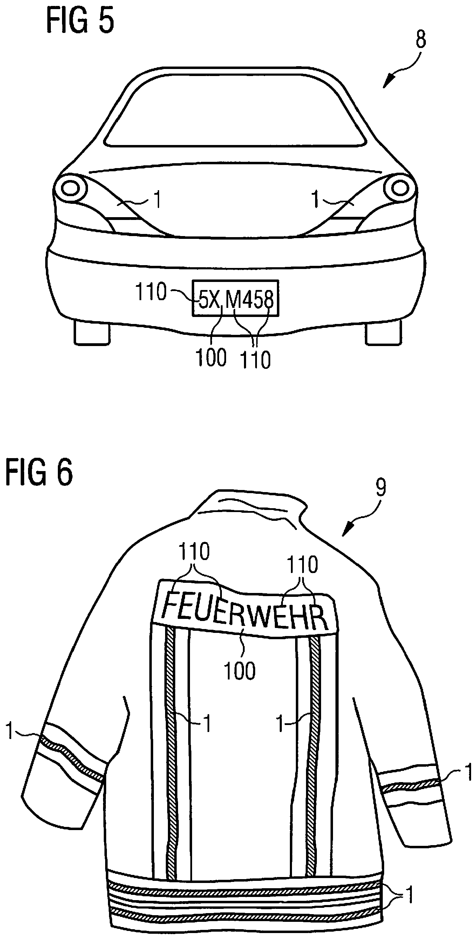

Figur 5 zeigt eine schematische Rückansicht eines Personenkraftwagens. Beleuchtungseinrichtungen 1, die beispielsweise analog zu der Beleuchtungseinrichtung 1A der Leuchte 10 gemäß Figur 3 ausgebildet sind, sind als Heckleuchten des Kraftfahrzeugs verwendet.

Zudem ist eine Anzeigetafel, nämlich ein Nummernschild 100, an dem Kraftfahrzeug angebracht, das ebenfalls eine Beleuchtungseinrichtung gemäß einem der vorhergehenden Ausführungsbeispiele, zum Beispiel gemäß dem zweiten Ausführungsbeispiel, enthält. Zur Darstellung der auf dem Nummernschild enthaltenen Information, insbesondere von Symbolen 110 wie Buchstaben und/oder Ziffern, ist beispielsweise die Lichtdurchtrittsfläche 7 stellenweise mit einer absorbierenden Schicht, beispielsweise mit einer Farbschicht, versehen, welche die Einkopplung von Umgebungslicht und die Auskopplung von reflektiertem oder von dem organischen lichtemittierenden Bauelement emittiertem Licht im Bereich der Symbole 110 verringert oder verhindert.

Das in Figur 6 dargestellte Bekleidungsstück ist mit - vorliegend streifenförmigen - Warnmarkierungen versehen, die von Beleuchtungseinrichtungen 1 gebildet sind oder Beleuchtungseinrichtungen 1 enthalten. Die Beleuchtungseinrichtungen sind beispielsweise gemäß einem der vorhergehenden Ausführungsbeispiele ausgeführt und vorzugsweise flexibel ausgeführt.

Das Bekleidungsstück 9 gemäß dem Ausführungsbeispiel der Figur 6 ist zusätzlich mit einer flexibel ausgeführten Anzeigetafel 100 versehen, die eine Beleuchtungseinrichtung 1 gemäß einem der vorhergehenden Ausführungsbeispiele enthält. Auf der Anzeigetafel 100 sind - zum Beispiel mittels einer absorbierenden Schicht - mehrere Symbole 110 dargestellt. Beispielsweise bilden die Symbole ein Wort oder mehrere Wörter. Bei einer bevorzugten Ausgestaltung ist das Bekleidungsstück 9 mit einer Stromversorgungsvorrichtung wie einer Batterie versehen, welche die Beleuchtungseinrichtung(en) 1 und/oder die Anzeigetafel 100 mit Strom versorgt.

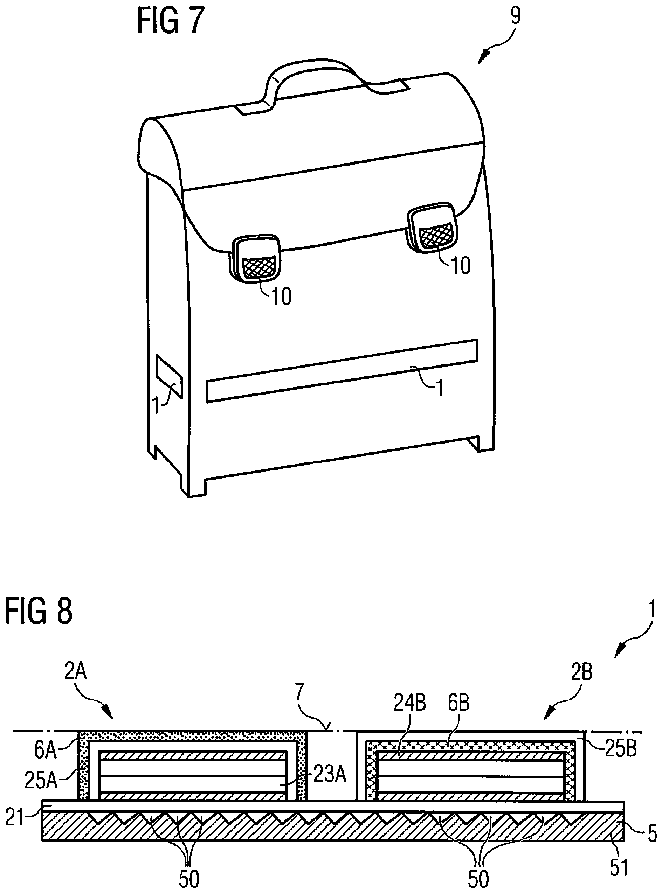

In Figur 7 ist ein Gepäckstück 9, vorliegend ein Schulranzen, schematisch perspektivisch dargestellt. Der Schulranzen 9 ist - analog zu dem Bekleidungsstück gemäß dem Ausführungsbeispiel der Figur 6 - mit beispielsweise streifenförmig ausgeführten Warnmarkierungen versehen, die von Beleuchtungseinrichtungen 1 gebildet sind oder Beleuchtungseinrichtungen 1 enthalten.

Zusätzlich sind vorliegend zwei Verschlusselemente 10 des Gepäckstücks 9, beispielsweise Schnallen oder Schlösser, als Leuchte ausgeführt, die jeweils eine Beleuchtungseinrichtung enthalten. Die Beleuchtungseinrichtung ist zum Beispiel gemäß dem ersten Ausführungsbeispiel oder einer der Varianten des ersten Ausführungsbeispiels ausgeführt.

Die Stromversorgung erfolgt beispielsweise mittels mindestens einer in das Gepäckstück 9 integrierten Batterie. Beispielsweise können die Verschlusselemente 10 jeweils eine Batterie enthalten. Die Warnmarkierungen 1 sind bei einer Ausgestaltung von mindestens einer weiteren in das Gepäckstück 9 integrierten Batterie mit Betriebsstrom versorgt.

Figur 8 zeigt einen schematischen Querschnitt durch eine Beleuchtungseinrichtung 1 gemäß einem vierten Ausführungsbeispiel. Die Beleuchtungseinrichtung 1 enthält eine Mehrzahl, vorliegend zwei, organische lichtemittierende Bauelemente 2A, 2B, die einander lateral benachbart sind. Anders ausgedrückt sind sie in Draufsicht auf die Lichtdurchtrittsfläche 7 nebeneinander angeordnet. Die organischen lichtemittierenden Bauelemente 2A, 2B sind vorliegend auf einem gemeinsamen Substrat 21 angeordnet.

Vorliegend sind die Bauelemente 2A und 2B mit unterschiedlichen Farbfilterschichten 6A beziehungsweise 6B versehen. Auf diese Weise erzeugt die Beleuchtungseinrichtung 1 im Bereich des ersten organischen Licht emittierenden Bauelements 2A einen anderen Farbeindruck als im Bereich des zweiten organischen Licht emittierenden Bauelements 2B. Beispielsweise ist mittels der verschiedenen Farbfilterschichten 6A, 6B ein Muster gebildet, mindestens ein Symbol dargestellt und/oder eine graphische Information - etwa eine Zeichnung und/oder ein Foto - wiedergegeben.

In Figur 8 sind in Zusammenhang mit den beiden organischen lichtemittierenden Bauelemente 2A, 2B zwei weitere exemplarische Beispiele für die Anordnung der Farbfilterschicht 6A beziehungsweise 6B gezeigt. Im linken Bereich, beim ersten organischen lichtemittierenden Bauelement 2A, ist die Farbfilterschicht 6A mit der Verkapselung 25A des organischen lichtemittierenden Bauelements 2A integriert ausgebildet. Vorliegend ist ein Farbstoff in der Kappe 25 enthalten, welche die funktionale Schichtenfolge 23A verkapselt.

Bei dem zweiten organischen Licht emittierenden Bauelement ist die Farbfilterschicht 6B als Haftvermittlungsschicht ausgebildet. Die Haftvermittlungsschicht, zum Beispiel eine Klebstoffschicht, verbindet die Kappe 25B im Wesentlichen vollflächig mit der zweiten Elektrode 24B.

Es ist auch denkbar, dass mindestens eines der organischen Licht emittierenden Bauelemente 2A, 2B keine Farbfilterschicht 6A, 6B aufweist, beispielsweise wie bei der Beleuchtungseinrichtung der Figur 2.

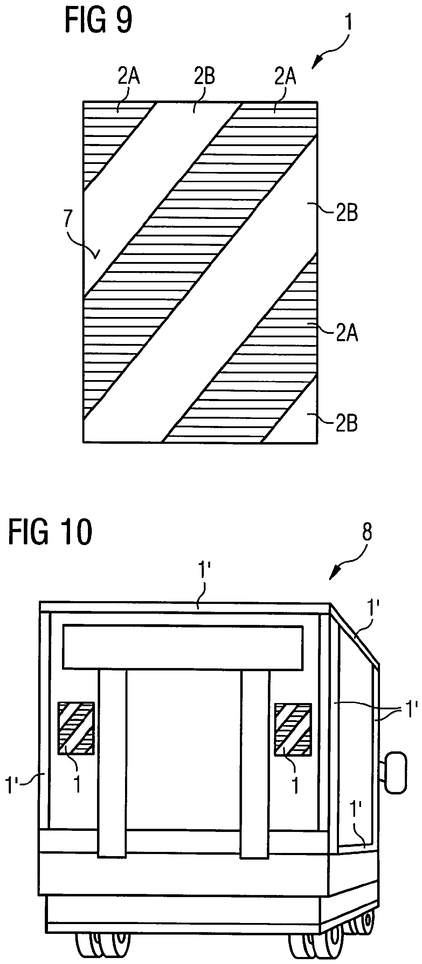

Figur 9 zeigt in schematischer Draufsicht eine Beleuchtungseinrichtung 1. Bei der Beleuchtungseinrichtung 1 bilden erste organische lichtemittierende Bauelemente 2A und zweite organische lichtemittierende Bauelemente 2B oder Stapel von organischen Licht emittierenden Bauelementen ein Muster. Das Muster ist in Draufsicht auf die Lichtdurchtrittsfläche 7 zum Beispiel streifenförmig.

Die ersten organischen lichtemittierenden Bauelemente 2A weisen zum Beispiel eine Farbfilterschicht 6A auf, welche beispielsweise einen roten Farbstoff enthält. Die zweiten organischen lichtemittierenden Bauelemente 2B oder Stapel von Bauelementen sind bei einer Ausgestaltung dazu vorgesehen, weißes Licht zu emittieren und vorliegend unbedeckt von einer Farbfilterschicht 6.

Alternativ kann das Muster gebildet werden, indem ein organisches Licht emittierendes Bauelement 2, das beispielsweise weißes Licht emittiert, stellenweise mit der Farbstoffschicht 6 versehen wird.

Figur 10 zeigt eine schematische perspektivische Ansicht eines Lastkraftwagens, der mit zwei Beleuchtungseinrichtungen 1 gemäß dem Ausführungsbeispiel der Figur 9 versehen ist. Die Beleuchtungseinrichtungen 1 stellen bei dem vorliegenden Ausführungsbeispiel Warnmarkierungen, zum Beispiel Warnmarkierungen für eine Hubladebühne dar.

Zusätzlich ist der Lastkraftwagen bei dem vorliegenden Ausführungsbeispiel mit Beleuchtungseinrichtungen 1' versehen, die beispielsweise entlang der Kanten des Laderaums des Lastkraftwagens verlaufen. Diese Beleuchtungseinrichtungen 1' stellen Umrissmarkierungen dar.

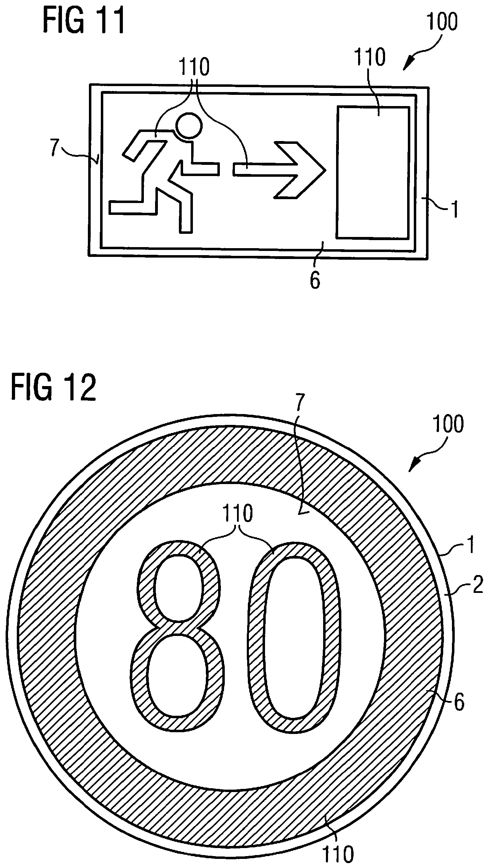

Figur 11 zeigt eine Anzeigetafel 100 in einer schematischen Draufsicht, auf die Lichtdurchtrittsfläche 7 der Beleuchtungseinrichtung 1. Auf der Anzeigetafel 100 ist zum Beispiel ein Piktogramm als Information dargestellt. Zur Darstellung der Information ist das organische Licht emittierende Bauelement 2, das vorliegend im Wesentlichen die gesamte Lichtdurchtrittsfläche 7 der Beleuchtungseinrichtung 1 beleuchtet, stellenweise von einer Farbfilterschicht 6 bedeckt.

Figur 12 zeigt ein zweites Ausführungsbeispiel für eine Anzeigetafel 100. Die Anzeigetafel gemäß Figur 12 ist ein Verkehrsschild. Die Lichtdurchtrittsfläche ist stellenweise mit einer absorbierenden Schicht bedeckt, welche die Form von Symbolen 110, vorliegend der Ziffern 8 und 0, hat. Das, beispielsweise weiß emittierende, organische lichtemittierende Bauelement 2 ist vorliegend in Draufsicht auf die Lichtdurchtrittsfläche 7 in einem Randbereich von einer Farbfilterschicht 6 bedeckt.

Die Farbfilterschicht 6 verläuft vorliegend ringförmig um die Symbole 110 herum. Die Beleuchtungseinrichtung hat eine kreisförmige Grundfläche. So ist mittels der Form der Farbfilterschicht 6 und der Beleuchtungseinrichtung 1 eine weitere Information dargestellt, nämlich dass es sich bei dem Verkehrszeichen 100 vorliegend um ein Verbotszeichen handelt.

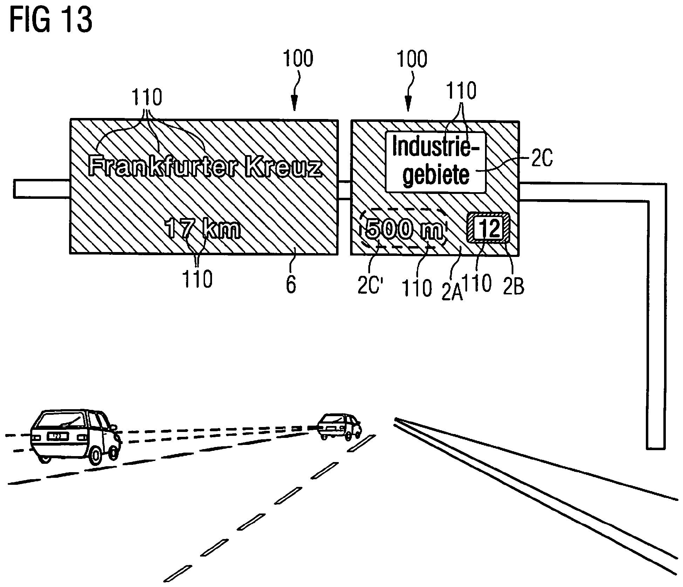

In Figur 13 sind zwei Anzeigetafeln 100 gemäß einem dritten Ausführungsbeispiel schematisch in Draufsicht auf die Lichtdurchtrittsfläche 7 dargestellt. Bei den dargestellten Anzeigetafeln 100 handelt es sich um Richtungshinweistafeln, beispielsweise für den Straßenverkehr.

Die linke Richtungshinweistafel 100 zeigt beispielhaft eine Ausgestaltung, bei der Symbole 110 mittels Aussparungen in einer Farbfilterschicht 6 dargestellt sind. Beispielsweise ist die Farbfilterschicht 6 auf ein organisches lichtemittierendes Bauelement, insbesondere auf dessen Verkapselung 25 und/oder auf dessen Substrat 21, aufgeklebt.

Die rechts beispielhaft dargestellte Anzeigetafel 100 weist eine Mehrzahl von einander lateral benachbarten organischen Licht emittierenden Bauelementen 2A, 2B, 2C und 2C' auf. Beispielsweise sind das zweite organische Licht emittierende Bauelement 2B und/oder die dritten organischen Licht emittierenden Bauelemente 2C, 2C' in Öffnungen des ersten organischen Licht emittierenden Bauelements 2A angeordnet. Insbesondere bilden die organischen Licht emittierenden Bauelemente 2A, 2B, 2C, 2C' eine im Wesentlichen zusammenhängende Leuchtfläche. Sie unterscheiden sich beispielsweise im Farbeindruck des jeweils ausgekoppelten Lichts.

Auf den zweiten und dritten organischen lichtemittierenden Bauelementen 2B, 2C, 2C' sind Symbole 110 dargestellt. Beispielsweise erfolgt die Darstellung der Symbole mittels einer absorbierenden Schicht, etwa im Fall der organischen Licht emittierenden Bauelemente 2B und 2C, oder sie erfolgt mittels einer stellenweise aufgebrachten Farbfilterschicht, etwa bei dem Bauelement 2C'.

## Patentansprüche

1. Beleuchtungseinrichtung (1, 1A, 1B) mit
- einem organischen lichtemittierenden Bauelement (2, 2A, 2B, 2C, 2C'), das ein Substrat (21) mit einer Vorderseite (3) und einer gegenüberliegenden Rückseite (4) enthält, und das eine funktionale Schichtenfolge (23, 23A) zur Lichterzeugung enthält, die auf der Vorderseite (3) des Substrats (21) angeordnet ist,
- einer Lichtdurchtrittsfläche (7, 7A, 7B), die dazu vorgesehen ist von dem organischen lichtemittierenden Bauelement (2, 2A, 2B, 2C, 2C') emittiertes Licht aus der Beleuchtungseinrichtung (1, 1A, 1B) auszukoppeln und Umgebungslicht in die Beleuchtungseinrichtung (1, 1A, 1B) einzukoppeln,
- einem Retroreflektor (5, 5A, 5B), der dazu vorgesehen ist zumindest einen Teil des durch die Lichtdurchtrittsfläche (7, 7A, 7B) eingekoppelten Umgebungslichts zur Lichtdurchtrittsfläche (7, 7A, 7B) zurück zu reflektieren und der auf der Rückseite (4) des Substrats (21) angeordnet ist, wobei
das organische lichtemittierende Bauelement (2, 2A, 2B, 2C, 2C') zumindest teilweise lichtdurchlässig ausgeführt ist und die funktionale Schichtenfolge (23, 23A) zwischen der Lichtdurchtrittsfläche (7, 7A, 7B) und dem Retroreflektor (5, 5A, 5B) angeordnet ist, wobei der Retroreflektor (5, 5A, 5B) wellenlängenselektiv ausgebildet ist, wobei, der Retroreflektor (5, 5A, 5B) elektromagnetische Strahlung mit der Wellenlänge eines Emissionsmaximums des organischen lichtemittierenden Bauelements (2, 2A, 2B, 2C, 2C') reflektiert, so dass der Anteil des Umgebungslichts, der von dem Retroreflektor (5, 5A, 5B) zur Lichtdurchtrittsfläche (7, 7A, 7B) zurück reflektiert und aus der Beleuchtungseinrichtung (1, 1A, 1B) ausgekoppelt wird, den gleichen Farbeindruck wie das von dem organischen lichtemittierenden Bauelement (2, 2A, 2B, 2C, 2C') emittierte Licht erzeugt.

2. Beleuchtungseinrichtung (1, 1A, 1B) gemäß Anspruch 1, wobei Umgebungslicht, das unter einem Eintrittswinkel auf die Lichtdurchtrittsfläche (7, 7A, 7B) trifft, in die Beleuchtungseinrichtung (1, 1A, 1B) eingekoppelt und vom Retroreflektor (5, 5A, 5B) zur Lichtdurchtrittsfläche (7, 7A, 7B) zurück reflektiert wird, unter einem Austrittswinkel zur Lichtdurchtrittsfläche (7, 7A, 7B) aus der Beleuchtungseinrichtung (1, 1A, 1B) ausgekoppelt wird, der den gleichen Wert hat wie der Eintrittswinkel.

3. Beleuchtungseinrichtung (1) gemäß einem der vorhergehenden Ansprüche, mit einer Farbfilterschicht (6), die zumindest stellenweise zwischen der Lichtdurchtrittsfläche (7) und der funktionalen Schichtenfolge (23) angeordnet ist.

4. Beleuchtungseinrichtung (1, 1A, 1B) gemäß einem der vorhergehenden Ansprüche mit einer Mehrzahl von organischen lichtemittierenden Bauelementen (2, 2A, 2B, 2C, 2C'), die lateral nebeneinander angeordnet sind.

5. Beleuchtungseinrichtung (1, 1A, 1B) gemäß Anspruch 4, bei der mindestens zwei lateral nebeneinander angeordneten organischen lichtemittierenden Bauelementen (2, 2A, 2B, 2C, 2C') unterschiedliche Farbfilter (6, 6A, 6B) zugeordnet sind.

6. Beleuchtungseinrichtung (1, 1A, 1B) gemäß einem der vorhergehenden Ansprüche, bei der der Retroreflektor (5, 5A, 5B) eine Spiegelschicht (51) mit einer Mehrzahl von Strahlformungselementen (50) aufweist, wobei mindestens ein Strahlformungselement (50) eine Vertiefung in der Oberfläche der Spiegelschicht (51) aufweist oder daraus besteht und/oder mindestens ein Strahlformungselement (50) ein Linsenelement aufweist oder daraus besteht.

7. Beleuchtungseinrichtung (1) gemäß einem der vorhergehenden Ansprüche, wobei
- der Retroreflektor (5) eine Spiegelschicht (51) mit einer Mehrzahl von Strahlformungselementen (50) aufweist,
- mindestens ein Strahlformungselement (50) eine Vertiefung in der Oberfläche der Spiegelschicht (51) und ein Linsenelement aufweist, und
- das Linsenelement teilweise in der Vertiefung angeordnet ist und in Richtung der Lichtdurchtrittsfläche (7) über die Vertiefung hinausragt.

8. Beleuchtungseinrichtung (1) gemäß einem der Ansprüche 1 bis 5, bei der der Retroreflektor (5) eine Mehrzahl von Strahlformungselementen (50) aufweist, die in einer zumindest teilweise lichtdurchlässigen Trägerschicht (52) angeordnet und stellenweise reflektierend ausgebildet sind.

9. Beleuchtungseinrichtung (1, 1A, 1B) gemäß einem der vorhergehenden Ansprüche, die flexibel ausgeführt ist.

10. Beleuchtungseinrichtung (1, 1A, 1B) gemäß einem der vorhergehenden Ansprüche, die eine Warnmarkierung oder ein Rückstrahler ist.

11. Leuchte (10) für ein Verkehrsmittel (8) mit einer Beleuchtungseinrichtung (1, 1A, 1B) gemäß einem der Ansprüche 1 bis 10.

12. Anzeigevorrichtung (100) mit einer Beleuchtungseinrichtung (1, 1A, 1B) gemäß einem der Ansprüche 1 bis 10.

13. Bekleidungsstück (9) oder Gepäckstück, das mit einer Beleuchtungseinrichtung (1, 1A, 1B) gemäß einem der Ansprüche 1 bis 10 und/oder mit einer Anzeigevorrichtung (100) gemäß Anspruch 12 versehen ist.

## Claims

1. Illumination device (1, 1A, 1B) comprising
- an organic light-emitting component (2, 2A, 2B, 2C, 2C'), which contains a substrate (21) with a front side (3) and opposite rear side (4), and which contains a functional layer sequence (23, 23A) for generating light,
- a light passage area (7, 7A, 7B), which is formed for coupling out light emitted by the organic light-emitting component (2, 2A, 2B, 2C, 2C') from the illumination device (1, 1A, 1B) and for coupling ambient light into the illumination device (1, 1A, 1B)
- a retroreflector (5, 5A, 5B), which is formed for reflecting at least part of the ambient light coupled in through the light passage area (7, 7A, 7B) back to the light passage area (7, 7A, 7B) and the retroreflector (5, 5A, 5B) is arranged on the rear side (4) of the substrate (21), wherein
the organic light-emitting component (2, 2A, 2B, 2C, 2C') is embodied such that it is at least partly light-transmissive and the functional layer sequence (23, 23A) is arranged between the light passage area (7, 7A, 7B) and the retroreflector (5, 5A, 5B), wherein the retroreflector (5, 5A, 5B) is formed in a wavelength-selective fashion, wherein
the retroreflector (5, 5A, 5B) reflects electromagnetic radiation having the wavelength of an emission maximum of the organic light-emitting component (2, 2A, 2B, 2C, 2C'), so that the part of the ambient light, which is reflected back by the retroreflector (5, 5A, 5B) to the light passage surface (7, 7A, 7B) and is coupled out from the illumination device (1, 1A, 1B), has the same color impression as the light emitted by the organic light-emitting component (2, 2A, 2B, 2C, 2C').

2. Illumination device (1, 1A, 1B) according to claim 1, wherein ambient light that impinges on the light passage area (7, 7A, 7B) at an entrance angle, is coupled into the illumination device (1, 1A, 1B) and reflected back to the light passage area (7, 7A, 7B) by the retroreflector (5, 5A, 5B) is coupled out from the illumination device (1, 1A, 1B) at an exit angle with respect to the light passage area (7, 7A, 7B), and the exit angle has the same value as the entrance angle.

3. Illumination device (1) according to one of the preceding claims, comprising a color filter layer (6), which is arranged at least in places between the light passage area (7) and the functional layer sequence (23).

4. Illumination device (1, 1A, 1B) according to one of the preceding claims comprising a plurality of organic light-emitting components (2, 2A, 2B, 2C, 2C') arranged laterally alongside one another.

5. Illumination device (1, 1A, 1B) according to claim 4, in which different color filters (6, 6A, 6B) are assigned to at least two organic light-emitting components (2, 2A, 2B, 2C, 2C') arranged laterally alongside one another.

6. Illumination device (1, 1A, 1B) according to one of the preceding claims, in which the retroreflector (5, 5A, 5B) has a mirror layer (51) having a plurality of beam shaping elements (50), wherein at least one beam shaping element (50) has or consists of a depression in the surface of the mirror layer (51) and/or at least one beam shaping element (50) has or consists of a lens element.

7. Illumination device (1) according to one of the preceding claims, wherein
- the retroreflector (5) has a mirror layer (51) having a plurality of beam shaping elements (50),
- at least one beam shaping element (50) has a depression in the surface of the mirror layer (51) and a lens element, and
- the lens element is partly arranged in the depression and projects beyond the depression in a direction of the light passage area (7).

8. Illumination device (1) according to one of claims 1 to 5, in which the retroreflector (5) has a plurality of beam shaping elements (50) which are arranged in an at least partly light-transmissive carrier layer (52) and are embodied in reflective fashion in places.

9. Illumination device (1, 1A, 1B) according to one of the preceding claims, which is embodied in flexible fashion.

10. Illumination device (1, 1A, 1B) according to any of the preceding claims, which is a warning marking or a reflector.

11. Luminaire (10) for a means of transport (8) comprising an illumination device (1, 1A, 1B) according to any of claims 1 to 10.

12. Display device (100) comprising an illumination device (1, 1A, 1B) according to any of claims 1 to 10.

13. Garment (9) or item of luggage provided with an illumination device (1, 1A, 1B) according to any of Claims 1 to 10 and/or with a display device (100) according to Claim 12.

## Revendications

1. Dispositif d'éclairage (1, 1A, 1B) comprenant
- un composant organique émetteur de lumière (2, 2A, 2B, 2C, 2C') comprenant un substrat (21) ayant une face avant (3) et une face arrière (4) opposée et une séquence de couches fonctionnelle (23, 23A) de génération de lumière disposée sur la face avant (3) du substrat (21),
- une surface de passage de lumière (7, 7A, 7B) destinée à découpler de la lumière émise par le composant organique émetteur de lumière (2, 2A, 2B, 2C, 2C') depuis le dispositif d'éclairage (1, 1A, 1B) et coupler de la lumière ambiante dans le dispositif d'éclairage (1, 1A, 1B),
- un rétroréflecteur (5, 5A, 5B) destiné à réfléter au moins une partie de la lumière ambiante couplée à travers la surface de passage de lumière (7, 7A, 7B) vers la surface de passage de lumière (7, 7A, 7B), et qui est disposé sur la face arrière (4) du substrat (21),
le composant organique émetteur de lumière (2, 2A, 2B, 2C, 2C') étant conçu sous forme au moins partiellement transparente à la lumière et la séquence de couches fonctionnelle (23, 23A) étant disposée entre la surface de passage de lumière (7, 7A, 7B) et le rétroréflecteur (5, 5A, 5B), le rétroréflecteur (5, 5A, 5B) étant prévu sous forme sélective en longueur d'onde,
le rétroréflecteur (5, 5A, 5B) réflétant du rayonnement électromagnétique à longueur d'onde d'un maximum d'émission du composant organique émetteur de lumière (2, 2A, 2B, 2C, 2C') de manière que la proportion de la lumière ambiante réflétée par le rétroréflecteur (5, 5A, 5B) vers la surface de passage de lumière (7, 7A, 7B) et couplée depuis le dispositif d'éclairage (1, 1A, 1B) génère la même impression de couleur que la lumière émise par le composamt organique émetteur de lumière (2, 2A, 2B, 2C, 2C').

2. Dispositif d'éclairage (1, 1A, 1B) selon la revendication 1, dans lequel de la lumière ambiante incidant sous un angle d'entrée sur la surface de passage de lumière (7, 7A, 7B) est couplée dans le dispositif d'éclairage (1, 1A, 1B) pour être réflétée par le rétroréflecteur (5, 5A, 5B) en retour vers la surface de passage de lumière (7, 7A, 7B), est découplée sous un angle de sortie vers la surface de passage de lumière (7, 7A, 7B) du dispositif d'éclairage (1, 1A, 1B) ayant la même valeur que l'angle d'entrée.

3. Dispositif d'éclairage (1) selon l'une des revendications précédentes, comportant une couche de filtre de couleur (6) disposée au moins localement entre la surface de passage de lumière (7) et la séquence de couches fonctionnelle (23).

4. Dispositif d'éclairage (1, 1A, 1B) selon l'une des revendications précédentes, comportant une pluralité de composants organiques émetteurs de lumière (2, 2A, 2B, 2C, 2C') qui sont disposés latéralement l'un à côté de l'autre.

5. Dispositif d'éclairage (1, 1A, 1B) selon la revendication 4, dans lequel à au moins deux composants organiques émetteurs de lumière (2, 2A, 2B, 2C, 2C') sont associés des filtres de couleur (6, 6A, 6B) différents.

6. Dispositif d'éclairage (1, 1A, 1B) selon l'une des revendications précédentes, dans lequel le rétroréflecteur (5, 5A, 5B) présente une couche miroir (51) comportant une pluralité d'éléments de mise en forme de faisceau (50), au moins un élément de mise en forme de faisceau (50) présentant une cavité dans la surface de la couche miroir (51) ou consistant en celle-ci et/ou au moins un élément de mise en forme de faisceau (50) comportant un élément lenticulaire.

7. Dispositif d'éclairage (1) selon l'une des revendications précédentes, dans lequel
- le rétroréflecteur (5) comporte une couche miroir (51) comportant une pluralité d'éléments de mise en forme de faisceau (50),
- au moins un élément de mise en forme de faisceau (50) présente une cavité dans la surface de la couche miroir (51) ainsi qu'un élément lenticulaire, et
- l'élément lenticulaire est disposé partiellement dans la cavité en faisant saillie de la cavité en direction de la surface de passage de lumière (7, 7A, 7B).

8. Dispositif d'éclairage (1) selon l'une des revendications 1 à 5, dans lequel le rétroréflecteur (5) présente une pluralité d'éléments de mise en forme de faisceau (50) disposés dans une couche support (52) prévue sous forme au moins partiellement transparente à la lumière et localement réfléchissante.

9. Dispositif d'éclairage (1, 1A, 1B) selon l'une des revendications précédentes, présentant une configuration flexible.

10. Dispositif d'éclairage (1, 1A, 1B) selon l'une des revendications précédentes conçu sous forme de marquage d'avertissement ou de réflecteur.

11. Luminaire (10) déstiné à un moyen de transport (8) comportant un dispositif d'éclairage (1, 1A, 1B) selon l'une des revendications 1 à 10.

12. Dispositif d'affichage (100) comportant un dispositif d'éclairage (1, 1A, 1B) selon l'une des revendications 1 à 10.

13. Pièce de vêtement (9) ou bagage pourvu/e d'un dispositif d'éclairage (1, 1A, 1B) selon l'une des revendications 1 à 10 et/ou d'un dispositif d'affichage (100) selon la revendication 12.
